Europäisches Patentamt

European Patent Office

Office européen des brevets

(19)

(11) Numéro de publication: **0 211 720 B1**

(12) **FASCICULE DE BREVET EUROPEEN**

(45) Date de publication du fascicule du brevet:
12.09.90

(51) Int. Cl.⁵: **H01L 27/14**

(21) Numéro de dépôt: **86401492.3**

(22) Date de dépôt: **04.07.86**

(54) Procédé de fabrication d'un détecteur d'image lumineuse, et détecteur matriciel bidimensionnel obtenu par ce procédé.

(30) Priorité: **19.07.85 FR 8511104**

(43) Date de publication de la demande:
**25.02.87 Bulletin 87/9**

(45) Mention de la délivrance du brevet:
**12.09.90 Bulletin 90/37**

(84) Etats contractants désignés:
**BE DE GB NL SE**

(56) Documents cités:
**EP-A- 0 032 847**
**US-A- 4 453 184**

**IEEE ELECTRON DEVICES LETTERS, vol. EDL-4, no. 10, octobre 1983, pages 375,376, IEEE, New York, US; S. MIURA et al.: "A monolithically integrated AlGaAs/GaAs p-i-n/FET photoreceiver by MOCVD"**
**EXTENDED ABSTRACTS OF THE 15TH CONFERENCE ON SOLID STATE DEVICES AND MATERIALS, 1983, pages 201-204, Tokyo, JP; F. OKUMURA et al.: "Amorphous Si:H linear image sensor operated by a-Si:H TFT array"**
**EXTENDED ABSTRACTS OF THE 16TH (1984 INTERNATIONAL) CONFERENCE ON SOLID STATE DEVICES AND MATERIALS, 1984, Kobe, pages 325-328, Tokyo, JP; S. UYA et al.: "A high**

(73) Titulaire: **THOMSON-CSF, 51, Esplanade du Général de Gaulle, F-92800 Puteaux(FR)**

(72) Inventeur: **Boulitrop, François, THOMSON-CSF SCPI 19, avenue de Messine, F-75008 Paris(FR)**
Inventeur: **Chartier, Eric, THOMSON-CSF SCPI 19, avenue de Messine, F-75008 Paris(FR)**
Inventeur: **Szydlo, Nicolas, THOMSON-CSF SCPI 19, avenue de Messine, F-75008 Paris(FR)**
Inventeur: **Hepp, Bernard, THOMSON-CSF SCPI 19, avenue de Messine, F-75008 Paris(FR)**
Inventeur: **Proust, Nicole, THOMSON-CSF SCPI 19, avenue de Messine, F-75008 Paris(FR)**

(74) Mandataire: **Lepercque, Jean et al, THOMSON-CSF SCPI, F-92045 PARIS LA DEFENSE CEDEX 67(FR)**

(56) Documents cités: (suite)
**resolution CCD image sensor overlaid with an a-Si:H photoconductive layer"**

## Description

L'invention concerne un procédé de fabrication d'un détecteur d'image lumineuse et un détecteur matriciel bidimensionnel obtenu par ce procédé. Elle se place dans le contexte de réalisation de circuits électroniques en couche mince sur de grandes surfaces.

L'application visée dans la présente invention est la commande intégrée de chaque point élémentaire d'un détecteur d'image matriciel à deux dimensions.

A l'heure actuelle, les principales applications associant la grande photo-conductivité du silicium amorphe à la possibilité de réaliser l'électronique de commande dans ce même matériau et sur le même support concerne les détecteurs d'images linéaires, de grande dimension (jusqu'à 20 cm), nécessaires à la lecture de documents de format A4 par déplacement latéral du document par rapport au senseur.

Trois structures différentes ont été envisagées pour réaliser de tels détecteurs linéaires :
- l'association d'un photoconducteur, d'une capacité de stockage, et d'un transistor en couche mince (T.F.T.) en silicium amorphe (a-Si) tel que cela est décrit dans l'article de M. MATSUMURA, revue "IEEE Electron Device Letters", vol. EDL - 1, n° 9, septembre 1980, p. 182 à 184 ;
- l'association d'une photodiode en silicium amorphe et d'un TFT en silicium amorphe ou polycristallin telle que décrite dans "Extended Abstracts of the 15th Conference on Solid State Devices and Materials", TOKYO (1983), p. 201 à 204 par F.OKUMURA ;
- l'association d'une photodiode et d'une diode bloquante en a-Si telle que décrite par Y. Yamamoto dans "Extended Abstracts of the 15 th conference on Solid State Devices and Materials", Tokyo (1983), p. 205 à 208.

Certaines de ces structures permettent d'obtenir des dispositifs présentant les caractéristiques suivantes :

| | |
|---|---|
| Longueur: | 50 mm |
| Résolution: | 8 à 10 bits/mm |
| Taille du pixel: | 100 μm × 70 μm |
| Temps de lecture: | 1 μs/bit sans multiplexage. |

Ces résultats laissent supposer la réalisation prochaine de senseurs linéaires permettant la reproduction de documents dans de bonnes conditions. Par exemple, pour des documents de 216 mm de largeur, à raison de 8 bits par millimètre et à une vitesse de défilement du papier de 5 ms par ligne.

Un détecteur d'image à deux dimensions, à système d'adressage et de lecture matriciel a aussi été développé tel que celui décrit dans l'article de S. UYA dans Extended Abstracts of the 16 th Conference on Solid State Devices an Materials, Kobe, (1984) pages 325 à 328. Le détecteur d'images décrit dans cet article est formé d'une matrice de photodiodes en silicium amorphe superposée à un réseau bidimensionnel de dispositifs à transfert de charges (D.T.C.) assurant la lecture des charges créées par la lumière. Le D.T.C. étant réalisé en silicium monocristallin, la taille du senseur se trouve limitée par des impératifs propres à la technologie du silicium monocristallin : prototype de moins de 1 cm de côté.

Par contre, l'invention concerne un détecteur d'image à deux dimensions de grandes dimensions à adressage et à lecture matriciels.

Le point élémentaire est constitué d'une photodiode en silicium amorphe reliée au drain d'un transistor de commande en silicium amorphe. La source de ce transistor est formée par une électrode-colonne, et la grille est commandée par une électrode ligne. La deuxième borne de la photodiode, commune à toutes les diodes, peut éventuellement être à un potentiel non nul de manière à polariser la diode en inverse.

L'invention bénéficie à la fois des progrès réalisés sur les diodes photovoltaiques et des performances récentes obtenues pour la réalisation des transistors de commande pour l'adressage d'écrans plats à cristaux liquides.

L'un des avantages principaux du procédé de l'invention réside dans le fait qu'il ne nécessite que trois niveaux de masquage. De plus, ils permet la réalisation de détecteurs de grandes surfaces par rapport à ce qui existe actuellement.

Une application intéressante de ce détecteur pourrait être par exemple la réalisation d'un détecteur bidimensionnel de rayons X à conditions d'interposer, entre la source de rayons X et le détecteur, un scintillateur qui absorbe les rayons X et réémet des rayons visibles. Ce serait un moyen pour remplacer les plaques photosensibles ou les intensificateurs d'images radiologiques actuellement utilisés en radiologie.

L'invention concerne donc un procédé de fabrication d'un détecteur d'image lumineuse, comportant les phases successives suivantes :

a) une première phase de dépôt d'une première couche d'un matériau conducteur sur un substrat ;

b) une deuxième phase de dépôt d'une couche d'un matériau semi-conducteur amorphe dopé d'un premier type déterminé ;

c) une troisième phase de dépôt d'une couche d'un matériau semi-conducteur amorphe non dopé ;

d) une quatrième phase de dépôt d'une couche d'un matériau semi-conducteur amorphe dopé d'un deuxième type inverse à celui d'un premier type de la deuxième phase ;

e) une cinquième phase de dépôt d'une première couche d'un matériau métallique ;

f) une sixième phase de gravure à travers un masque, dans les différentes couches déposées précédemment à partir de la deuxième phase de dépôt, de photodiodes ;

g) une septième phase de dépôt d'une première couche d'un matériau isolant d'une épaisseur égale à celle des photodiodes ;

h) une huitième phase d'usinage du matériau isolant se trouvant au-dessus des photodiodes de façon à conserver le matériau isolant se trouvant entre lesdites photodiodes ;

i) une neuvième phase de dépôt d'une deuxième couche d'un matériau métallique ;

j) une dixième phase de dépôt d'une couche de matériau semi-conducteur dopé de type N ;

k) une onzième phase de gravure à travers un masque, dans la couche de matériau semi-conducteur déposée au cours de la neuvième phase précédente et dans la deuxième couche de matériau métallique, d'éléments de connexion en contact chacun avec une photodiode et de colonnes situées sur le milieu isolant à proximité desdits éléments de connexion ;

l) une douzième phase de dépôt d'une couche d'un matériau semi-conducteur amorphe non dopé ;

m) une treizième phase de dépôt d'une deuxième couche d'un matériau isolant ;

n) une quatorzième phase de dépôt d'une deuxième couche d'un matériau métallique ;

o) une quinzième phase de gravure à travers un masque, dans les couches de matériau semi-conducteur, de matériau isolant et de matériau métallique déposées au cours des douzième, treizième et quatorzième phases précédentes, de lignes chevauchant lesdits éléments de connexion et lesdites colonnes.

L'invention concerne donc un détecteur matriciel bidimensionnel comportant :

- sur un substrat revêtu d'une première couche d'un matériau conducteur, une matrice de photodiodes en forme de plots arrangés en lignes et colonnes et comprenant chacune par dépôts successifs une couche de semi-conducteur amorphe dopé d'un premier type déterminé, une couche de semi-conducteur amorphe non dopé, une couche de semi-conducteur amorphe dopé d'un deuxième type inverse à celui du premier type, une deuxième couche d'un matériau conducteur, chaque photodiode étant isolée des photodiodes voisines par un matériau isolant ;
- sur le matériau isolant des colonnes de matériau disposées selon les colonnes des photodiodes et comprenant chacune par dépôts successifs une couche d'un matériau métallique et une couche de semi-conducteur amorphe dopé ;
- des éléments de connexion connectés chacun à une photodiode par la couche de matériau conducteur de la photodiode, situés à proximité d'une colonne et comprenant chacun par dépôts successifs une couche de matériau métallique et une couche de semi-conducteur amorphe dopé ;
- des lignes de matériau disposées selon les lignes des photodiodes, chaque ligne comprenant par dépôts successifs une couche de semi-conducteur amorphe non dopé, une couche d'isolant et une couche de matériau métallique, lesdites lignes chevauchant les colonnes ainsi qu'un élément de connexion à chaque point de croisement d'une ligne et d'une colonne, et formant ainsi des transistors de commande.

Les différents objets et caractéristiques de l'invention vont maintenant être décrits en se reportant aux figures annexées qui représentent :

- les figures 1 à 4, le procédé de réalisation d'une photodiode E selon l'invention ;
- les figures 5 à 7, le procédé de réalisation d'un transistor de commande du détecteur selon l'invention ;
- la figure 8, une vue en perspective d'une photodiode selon l'invention ;

- la figure 9, une vue en perspective d'une photodiode E, d'un élément de connexion CX et d'une colonne CL ;
- la figure 10, une vue en perspective d'un détecteur selon l'invention ;
- les figures 11 et 12 des vues de dessus représentant des dispositions matricielles d'un détecteur selon l'invention.

Selon l'invention, le procédé de fabrication de détecteurs d'images lumineuses prévoit, au cours d'une première phase, le dépôt sur un substrat 1, tel que du verre, d'une couche d'un matériau conducteur 2 qui pourra être selon le mode d'utilisation un conducteur en matériau transparent comme on le verra ultérieurement. On dépose ainsi une fine couche d'oxyde mixte d'étain et d'indium (ITO) ou un matériau équivalent ($In_2O_3$, $SnO_2$). Une telle couche aura une épaisseur de 50 à 150 nm (500 à 1500 Angstroem) (125 nm (1250 Angstroem) par exemple) et on procède à une oxydation de la couche.

Au cours d'une deuxième phase, on dépose une couche 3 de silicium amorphe dopée P. Ce dépôt se fait par une méthode connue de dépôt de silicium amorphe telle que décharge luminescente, pulvérisation réactive.

Au cours d'une troisième phase, on dépose une couche 4 de silicium amorphe non dopé par une méthode identique à celle de la phase précédente.

Au cours d'une quatrième phase, on dépose une couche 5 de silicium amorphe dopé N de la même façon que précédemment.

Au cours d'une cinquième phase, on dépose par évaporation sous vide ou pulvérisation sous vide, une fine couche métallique 6 tel que de l'aluminium.

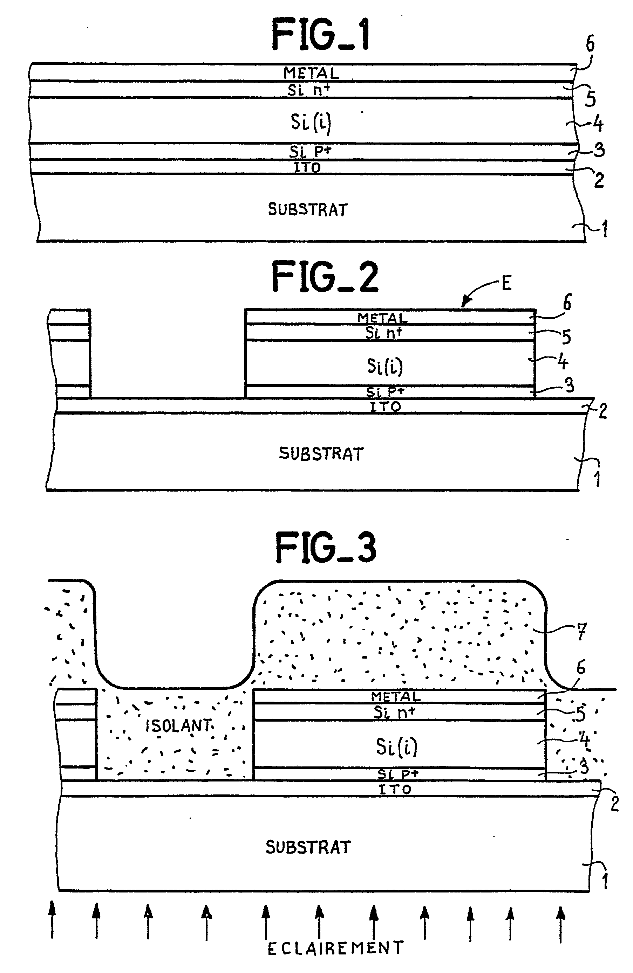

On obtient ainsi une structure représentée en figure 1. L'épaisseur des quatre couches (silicium et métal) 3, 4, 5 et 6 est d'environ 1 μm.

Au cours d'une sixième phase, on découpe dans ces quatres couches des photodiodes telle que la photodiode E de la figure 2. Cette phase de découpe peut se faire par photolithographie. Cette photolithographie implique un masquage ne nécessitant pas une grande précision de dimensions ni de positionnement. Le masquage est suivi d'une gravure sèche ou chimique des quatre couches 3, 4, 5 et 6.

Sur la figure 2, on obtient ainsi une photodiode E de type PIN. Cependant, la couche de silicium 3 aurait pu être dopée de type N et la couche de silicium 5, dopée de type P. On aurait alors obtenu un photodiode de type NIP.

Au cours d'une septième phase, on dépose une couche d'isolant 7 d'épaisseur égale à l'épaisseur de la photodiode E. L'isolant utilisé peut être de la silice ou un nitrure de silicium. La technique de dépôt employée peut être une décharge luminescente ou une pulvérisation réactive à une température compatible avec la nature de la photodiode E. On obtient ainsi une structure du type représenté par la figure 3.

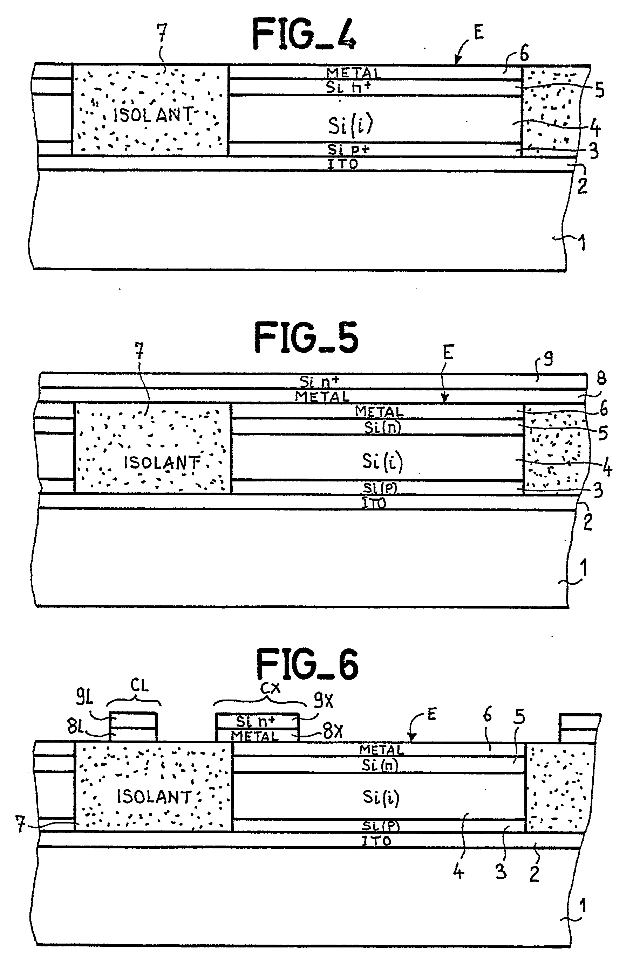

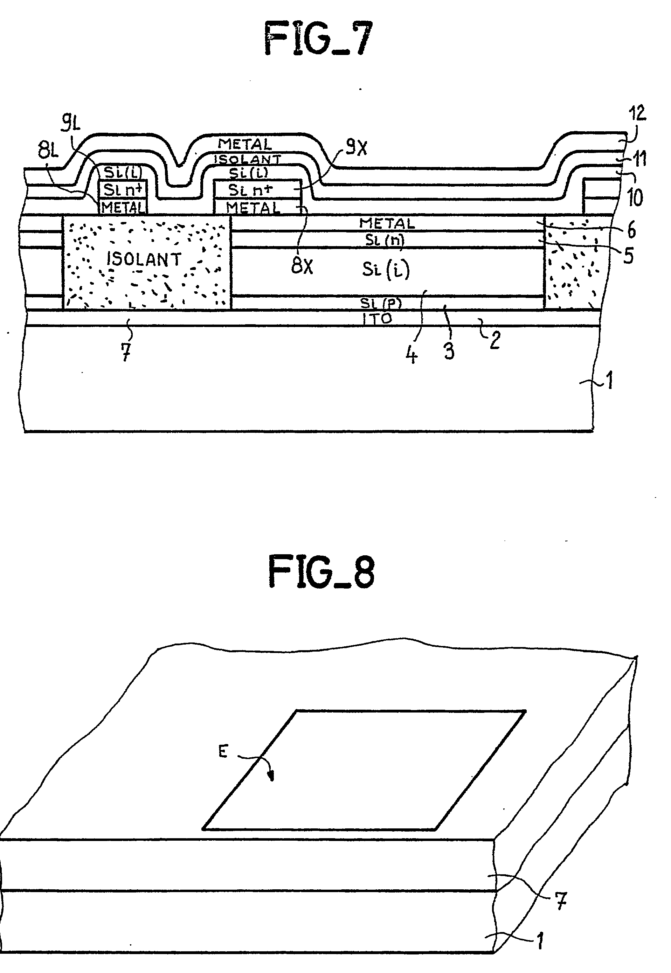

Au cours d'une huitième phase, on procède à l'élimination du matériau isolant 7 situé à la surface de la couche métallique 6 de la photodiode E. Pour cela, on recouvre la surface de l'isolant 7 d'une couche d'une résine négative. On insole alors l'ensemble à travers le substrat 1 à l'aide d'une source d'éclairement comme cela est représenté par les flèches indiquées sur la figure 3. La couche métallique 6 de la photodiode E sert de masque pour l'isolant 7 situé à dessus de la photodiode E et après développement, cet isolant est éliminé. On obtient une structure telle que représentée en figure 4. Comme on le voit sur la vue en perspective de la figure 8, la surface supérieure de l'électrode E affleure la surface supérieure de l'isolant 7.

Au cours d'une neuvième phase on dépose une couche métallique 8 tel que du chrome, du palladium ou du molybdène, de la même façon que lors du dépôt de la couche métallique 6, c'est-à-dire par évaporation ou pulvérisation cathodique sous vide. L'épaisseur de la couche 8 doit être de quelques dizaines de nanomètres (centaines d'Angstroem), 60 nm (600 Angstroem) par exemple.

Au cours d'une dixième phase, on dépose une couche de matériau semi-conducteur 9 fortement dopé de type n tel que du silicium amorphe. Ce dépôt se fait par une méthode connue de dépôt de silicium amorphe telle que décharge luminescente ou pulvérisation réactive. L'épaisseur de cette couche sera environ de 40 nm (400 Angstroem) (entre 30 et 150 nm (300 et 1500 Angstroem)). On obtient ainsi une structure telle que représentée en figure 5.

Au cours d'une onzième phase, on procède à la gravure des deux couches précédemment déposées (couche métallique 8 et couche de silicium amorphe 9) de façon à réaliser des éléments de connexion CX et des colonnes CL tel que représentés en figure 6. L'élément de connexion CX est constitué d'une couche 8X et d'une couche 9X gravées dans les couches 8 et 9 de la figure 5. De même, la colonne CL est constituée d'une couche 8L et d'une couche 9L gravées dans les couches 8 et 9.

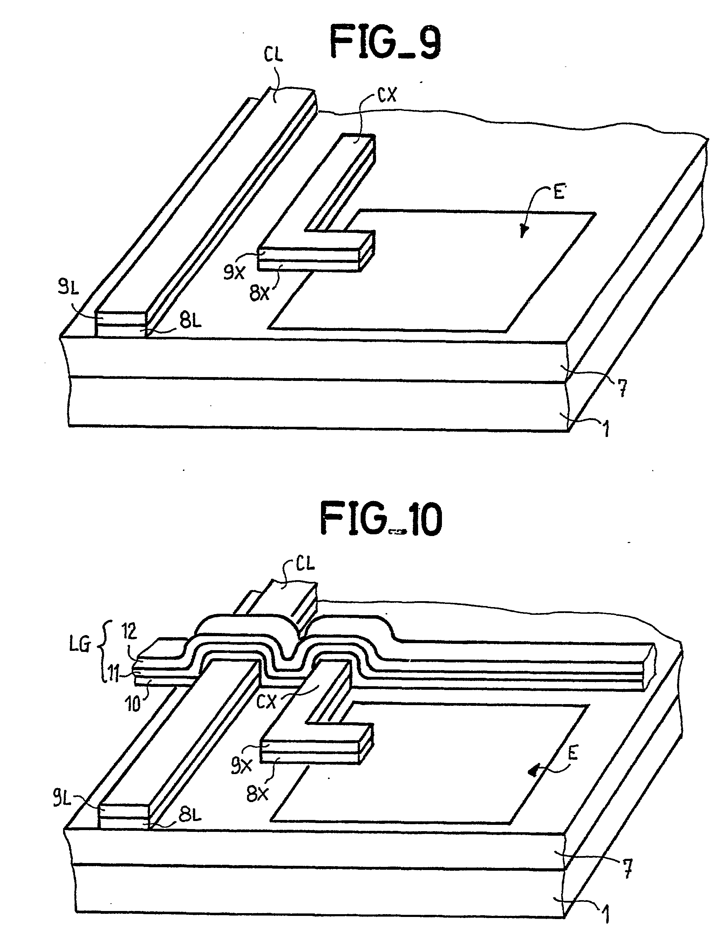

La figure 9 donne une vue en perspective de la structure ainsi obtenue. L'élément de connexion CX a la forme générale d'un L. L'une des branches du L est en contact avec l'électrode E. L'autre branche du L est parallèle à la colonne CL.

Cette phase de gravure se fait par photolithographie et permet de définir à elle seule la géométrie du transistor (longueur du canal du transistor).

Au cours d'une douzième phase, on procède au dépôt d'une couche de semi-conducteur 10, tel que du silicium amorphe non dopé. Ce dépôt se fait à l'aide d'une méthode connue telle qu'une décharge luminescente. L'épaisseur de la couche obtenue est d'environ 300 nm (3000 Angstroem).

Au cours d'une treizième phase, on prévoit le dépôt d'une couche d'isolant 11 (isolant de grille) par une méthode analogue à celle de la douzième phase précédente. L'épaisseur de la couche d'isolant 11 est d'environ 150 nm (1500 Angstroem). L'isolant utilisé pourra, par exemple, être un nitrure.

Au cours d'une quatorzième phase, on procède au dépôt d'une couche d'un matériau métallique 12, tel que du chrome, du palladium, du molybdène, etc. Le procédé de dépôt d'une telle couche sera analogue à celui de la neuvième phase de dépôt de la couche 8. L'épaisseur de la couche 12 sera d'environ 300 nm (3000 Angstroem). On obtient, à l'issue des douzième, treizième et quatorzième phases, une structure telle que représentée en figure 7.

Au cours d'une quinzième phase, on grave la couche métallique 12, la couche d'isolant 11, la couche de silicium 10, de façon à obtenir des lignes LG.

Sur la vue en perspective de la figure 10, on voit ainsi une ligne LG perpendiculaire à la colonne CL ainsi qu'une portion de l'élément de connexion CX. Cette opération de gravure se fait par photolithographie.

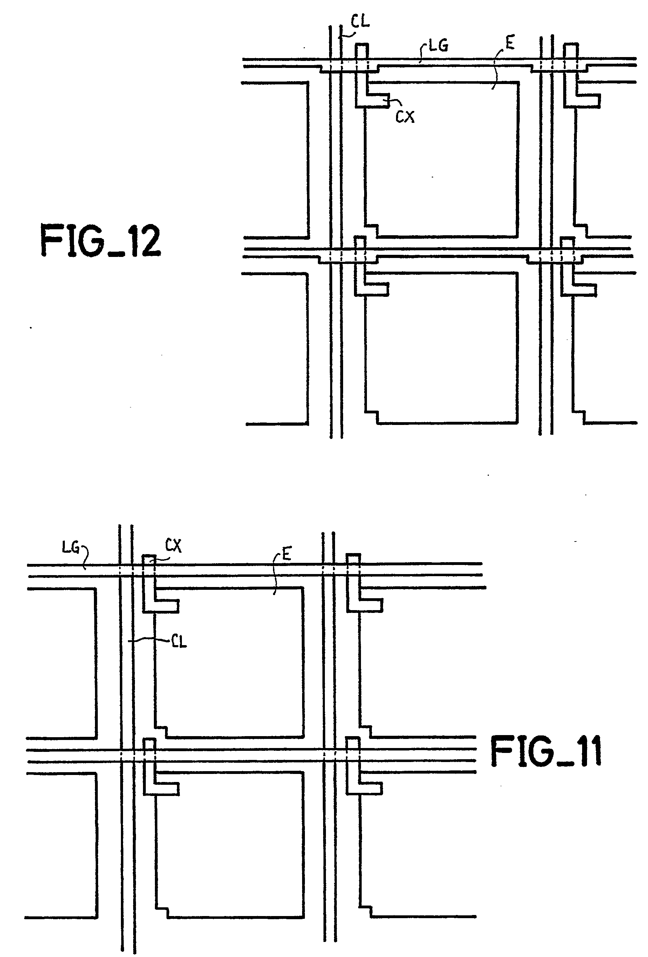

À ce stade, le détecteur d'image matriciel intégré est réalisé comme représenté en figure 11. Le substrat 1, porte des lignes LG, des colonnes CL, des éléments de connexion CX à chaque point de croisement d'une ligne et d'une colonne, ainsi qu'une photodiode E connectée à chaque élément de connexion CX.

Par ailleurs, comme cela est représenté en figure 12, chaque ligne LG possède un élargissement au niveau de chaque point de croisement (transistor). Ceci permet de diminuer l'effet de transistor parasite pouvant exister entre le drain du transistor principal et la colonne suivante.

Il convient d'ajouter que les dépôts de couches de silicium amorphe 10 et de matériau isolant 11, effectués au cours des douzième et treizième phases précédemment décrites, sont faits à travers un masque préservant la périphérie du substrat 1 de ces dépôts. Ainsi, les contacts périphériques de chaque ligne LG sont réalisés directement sur le substrat par la couche métallique 12 déposée.

Il convient également de signaler que l'opération de dépôt de la douzième phase peut être un semiconducteur électriquement compensé ou même faiblement de type p afin d'en diminuer la photoconductivité et ainsi de limiter l'influence de la lumière sur les caractéristiques des transistors.

Les connexions électriques aux lignes et colonnes ne sont pas représentées sur les figures annexées et se font de manière connue dans la technique.

Un détecteur matriciel décrit précédemment permet de détecter une image lumineuse. Le substrat 1 et la couche 2 étant transparente au flux lumineux émis par l'image à détecter, ce flux lumineux éclaire une photodiode E, à travers le substrat 1 et la couche 2 ce qui déclenche la conduction de cette photodiode. L'exploration par lignes et colonnes du détecteur matriciel permet de détecter le flux lumineux reçu par chaque photodiode E et de lire l'image reçue décomposée point par point (ou photodiode E).

Dans ces conditions l'image lumineuse reçue traverse le substrat 1. Si l'on veut éviter la traversée de ce substrat par l'image lumineuse pour éviter toute déformation, on prévoit alors que la couche métallique 6 de la photodiode 4 soit une couche de matériau conducteur transparent à l'égard de ce flux lumineux. Ce matériau déposé au cours de la cinquième phase précédente se fait alors par pulvérisation cathodique sous vide et le matériau utilisé peut être de l'ITO ou du $SnO_2$. Selon ce type de réalisation, la couche 2 peut alors être opaque pour le flux lumineux transmis.

L'image lumineuse arrive donc par le dessus du composant réalisé, à travers la couche de matériau conducteur transparent 6, sur les électrodes E. L'image est ainsi formée directement sur les photodiodes. De plus la couche métallique 12 de chaque ligne LG permet d'écranter de la lumière incidente les transistors des points de croisement des lignes et colonnes.

L'invention trouvera une application particulièrement intéressante dans les systèmes de radiographie, permettant alors d'enregistrer électriquement dans une mémoire une image radiographique reçue. Les types de matériaux utilisés pour la fabrication des couches transparentes ou non (substrat 1, couche 2, couche métallique 6) doivent donc être adaptés à la nature des rayonnements émis par l'image à détecter selon le type d'application.

**Revendications**

1. Procédé de fabrication d'un détecteur d'image lumineuse comportant les phases successives suivantes :

   a) une première phase de dépôt d'une première couche d'un matériau conducteur (2) sur un substrat (1) ;

   b) une deuxième phase de dépôt d'une couche (3) d'un matériau semi-conducteur amorphe dopé d'un premier type déterminé (P ou N) ;

   c) une troisième phase de dépôt d'une couche (4) d'un matériau semi-conducteur amorphe non dopé ;

   d) une quatrième phase de dépôt d'une couche (5) d'un matériau semi-conducteur amorphe dopé d'un deuxième type (N ou P) inverse à celui du premier type de la deuxième phase ;

   e) une cinquième phase de dépôt d'une première couche d'un matériau métallique (6) ;

   f) une sixième phase de gravure à travers un masque, dans les différentes couches (3 à 6) déposées précédemment à partir de la deuxième phase de dépôt, de photodiodes (E) ;

   g) une septième phase de dépôt d'une première couche d'un matériau isolant (7) d'une épaisseur égale à celle des photodiodes (E) ;

   h) une huitième phase d'usinage du matériau isolant (7) se trouvant au-dessus des photodiodes (E) de façon à conserver le matériau isolant se trouvant entre lesdites photodiodes (E) ;

   i) une neuvième phase de dépôt d'une deuxième couche d'un matériau métallique (8) ;

   j) une dixième phase de dépôt d'une couche (9) de matériau semi-conducteur dopé de type N ;

   k) une onzième phase de gravure à travers un masque, dans la couche (9) de matériau semi-conducteur déposée au cours de la neuvième phase précédente et dans la deuxième couche de matériau métallique (8), d'éléments de connexion (CX) en contact chacun avec une photodiode (E) et de colonnes situées sur le matériau (7) isolant à proximité desdits éléments de connexion (CX);

   l) une douzième phase de dépôt d'une couche (10) d'un matériau semi-conducteur amorphe non dopé ;

   m) une treizième phase de dépôt d'une deuxième couche (11) d'un matériau isolant ;

   n) une quatorzième phase de dépôt d'une deuxième couche (12) d'un matériau métallique ;

   o) une quinzième phase de gravure à travers un masque, dans les couches de matériau semi-conducteur (10), de matériau isolant (11) et matériau métallique (12) déposées au cours des douzième, treizième et quatorzième phases précédentes, de lignes LG chevauchant lesdits éléments de connexion (CX) et lesdites colonnes (CL) et formant ainsi des transistors de commande.

2. Procédé selon la revendication 1, caractérisé en ce que la première couche de matériau conducteur (2) déposée au cours de la première phase, est transparente au flux lumineux émis par l'image lumineuse et que la première couche de matériau métallique (6) déposée au cours de la cinquième phase, est opaque audit flux lumineux.

3. Procédé selon la revendication 1, caractérisé en ce que la première couche de matériau conducteur (2) est opaque au flux lumineux émis par l'image lumineuse et que la première couche de matériau métallique (6) est transparente audit flux lumineux.

4. Procédé selon la revendication 1, caractérisé en ce que la première couche de matériau conducteur (2) et la première couche de matériau métallique (6) sont toutes deux transparentes au flux lumineux émis par l'image lumineuse.

5. Procédé selon l'une quelconque des revendications 1, 2 ou 4, caractérisé en ce que le substrat (1) est en matériau transparent au flux lumineux émis par l'image lumineuse.

6. Procédé selon la revendication 1, caractérisé en ce que les méthodes de dépôts des couches de matériau semi-conducteur sont des décharges luminescentes.

7. Procédé selon la revendication 1, caractérisé en ce que les dépôts de couches de matériau métallique se font par évaporation sous vide.

8. Procédé selon la revendication 1, caractérisé en ce que les dépôts de couches de matériau métallique se font par pulvérisation cathodique sous vide.

9. Procédé selon la revendication 1, caractérisé en ce que la sixième phase de gravure consiste en une photolithographie comprenant un masquage des zones correspondant aux photodiodes (E) à obtenir suivi d'une gravure sèche ou chimique des couches (3 à 6) déposées au cours des deuxième, troisième, quatrième et cinquième phases.

10. Procédé selon la revendication 1, caractérisé en ce que la septième phase se fait par décharge luminescente.

11. Procédé selon la revendication 1, caractérisé en ce que la septième phase se fait par pulvérisation réactive.

12. Procédé selon les revendications 2 et 5, caractérisé en ce que l'élimination de l'isolant au-dessus des photodiodes se fait au moyen d'une résine négative et insolation à travers le substrat (1), la couche de matériau métallique (6) déposée au cours de la cinquième phase servant de masque, la gravure étant réalisée par une technique sèche.

13. Procédé selon les revendications 2 et 5, caractérisé en ce que le matériau isolant (7) déposé au cours de la septième phase est un polyimide photosensible et que son élimination au-dessus des photodiodes se fait par insolation à travers le substrat (1), les photodiodes servant de masque, puis par développement et enlèvement des parties non insolées et enfin par recuit du polyimide restant entre les photodiodes (E) à une température compatible avec lesdites photodiodes (E).

14. Procédé selon la revendication 1, caractérisé en ce que le matériau semi-conducteur des couches (3, 4, 5, 9, 10), déposées au cours des deuxième, troisième, quatrième, dixième et douzième phases, est du silicium amorphe.

15. Procédé selon la revendication 1, caractérisé en ce que la couche (3) de matériau semi-conducteur, déposé au cours de la deuxième phase, est un alliage de silicium carbone.

16. Procédé selon la revendication 1, caractérisé en ce que les douzième et treizième phases de dépôts de couches de semi-conducteur (10) et d'isolant (11) se font à travers un masque préservant la périphérie de la couche (2) de matériau conducteur déposée au cours de la première phase de façon que les lignes métalliques (12) déposées au cours des phases ultérieures donnent lieu à des contacts situés directement sur ladite couche de matériau conducteur.

17. Procédé selon la revendication 1, caractérisé en ce que la douzième phase est un dépôt de semi-conducteur électriquement compensée afin d'en diminuer la photoconductivité.

18. Procédé selon la revendication 1, caractérisé en ce que la douzième phase est un dépôt de semi-conducteur dopé faiblement de type p afin d'en diminuer la photoconductivité.

19. Détecteur matriciel bidimensionnel comportant :
- sur un substrat (1) revêtu d'une première couche d'un matériau conducteur (2), une matrice de photodiodes (E) en forme de plots arrangés en lignes et colonnes et comprenant chacune par dépôts successifs une couche (3) de semi-conducteur amorphe dopé d'un premier type déterminé (P ou N), une couche (4) de semi-conducteur amorphe non dopé, une couche (5) de semi-conducteur amorphe dopé d'un deuxième type (N ou P) inverse à celui du premier type, une deuxième couche (6) d'un matériau conducteur, chaque photodiode étant isolé des photodiodes voisines par un matériau isolant (7) ;
- sur le matériau isolant (7), des colonnes de matériau (CL) disposées selon les colonnes des photodiodes (E) et comprenant chacune par dépôts successifs une couche d'un matériau métallique (8L) et une couche de semi-conducteur amorphe dopé (9L) ;
- des éléments de connexion (CX) connectés chacun à une photodiode (E) par la couche (6) de matériau conducteur de la photodiode, situés à proximité d'une colonne (CL) et comprenant chacun par dépôts successifs une couche de matériau métallique (8X) et une couche de semi-conducteur amorphe dopé (9X) ;
- des lignes de matériau (LG) disposées selon les lignes des photodiodes (E), chaque ligne comprenant par dépôts successifs une couche de semi-conducteur amorphe non dopé (10), une couche d'isolant (11) et une couche de matériau métallique (12), lesdites lignes chevauchant les colonnes (CL) ainsi qu'un élément de connexion (CX) à chaque point de croisement d'une ligne (LG) et d'une colonne (CL) et formant ainsi des transistors de commande.

20. Détecteur selon la revendication 19, caractérisé en ce que la deuxième couche de matériau conducteur (6) est transparente au flux émis par l'image lumineuse.

21. Détecteur selon la revendication 19, caractérisé en ce que la première couche de matériau conducteur (2) est transparente au flux émis par l'image lumineuse.

22. Détecteur selon la revendication 20, caractérisé en ce que la première couche de matériau conducteur (2) est opaque au flux émis par l'image lumineuse.

**Claims**

1. A method for the manufacture of a luminous image detector comprising the following successive phases:
(a) a first phase of deposition of a first layer of a conductive material (2) on a substrate (1);
(b) a second phase of deposition of a layer (3) of an amorphous semiconductor material with a first type of doping (P or N);
(c) a third phase of deposition of a layer (4) of a non-doped amorphous semiconductor material;
(d) a fourth phase of deposition of a layer (5) of an amorphous semiconductor material with a second type of doping (N or P) opposite to the type of doping of the first type of the second phase;
(e) a fifth phase of deposition of a first layer of a metallic material (6);
(f) a sixth phase of etching through a mask, in the different layers (3 through 6) deposited previously as from the second phase of deposition onwards, of photodiodes (E);
(g) a seventh phase of deposition of a first layer of an insulating material (7) with a thickness equal to that of the photodiodes (E);
(h) an eighth phase of treating the insulating material (7) located over the photodiodes (E) in such a manner as to maintain the insulating material located between the said photodiodes (E):
(i) a ninth phase of deposition of a second layer of a metallic material (8);
(j) a tenth phase of deposition of a layer (9) of semiconductor material with the N type of doping:
(k) an eleventh phase of etching through a mask, in the layer (9) of semiconductor material deposited in the course of the ninth preceding phase and in the second layer of metallic material (8), of connection elements (CX) each in contact with a photodiode (E) and columns situated on the insulating material (7) in the vicinity of the said connection elements (CX);
(l) a twelfth phase of deposition of a layer (10) of a non-doped amorphous semiconductor material;
(m) a thirteenth phase of deposition of a second layer (11) of an insulating material;
(n) a fourteenth phase of deposition of a second layer (12) of a metallic material; and
(o) a fifteenth phase of etching through a mask, in the layers of semiconductor material (10), of insulating material (11) and metallic material (12) deposited during the course of the twelfth, thirteenth and fourteenth preceding phases, of lines LG spanning the said connection elements (CX) and the said columns (CL) and thus forming control transistors.

2. The method as claimed in claim 1, characterized in that the first layer of conductive material (2) deposited in the course of the first phase, is transparent to the luminous flux emitted by the luminous image and in that the first layer of metallic material (6) deposited in the course of the fifth phase, is opaque to the said luminous flux.

3. The method as claimed in claim 1, characterized in that the first layer of conductive material (2) is opaque to the luminous flux emitted by the luminous image and in that the first layer of metallic material (6) is transparent to the said luminous flux.

4. The method as claimed in claim 1, characterized in that the first layer of conductive material (2) and the first layer of metallic material (6) are both transparent to the luminous flux emitted by the luminous image.

5. The method as claimed in any one of the preceding claims 1, 2 and 4, characterized in that the substrate (1) is a material transparent for the luminous flux emitted by the luminous image.

6. The method as claimed in claim 1, characterized in that the methods of deposition of the layers of semiconductor material use luminescent discharges.

7. The method as claimed in claim 1, characterized in that the deposition of the layers of metallic material is performed by vacuum evaporation.

8. The method as claimed in claim 1, characterized in that the deposition of the layers of metallic material is performed by cathodic sputtering.

9. The method as claimed in claim 1, characterized in that the sixth phase of etching is performed by a photolithographic process comprising masking the zones corresponding to the photodiodes (E) in order to obtain, followed by dry or wet chemical etching, layers (3 through 6) deposited in the course of the second, third, fourth and fifth phases.

10. The method as claimed in claim 1, characterized in that the seventh phase is performed by luminescent discharge.

11. The method as claimed in claim 1, characterized in that the seventh phase is performed by reactive sputtering.

12. The method as claimed in claim 2 and in claim 5, characterized in that the removal of the insulator over the photodiodes is performed by means of negative resin and exposure through the substrate (1), the layer of metallic material (6) deposited in the course of the fifth phase serving as a mask, the etching being performed by a dry technique.

13. The method as claimed in claim 2 and claim 5, characterized in that the insulating material (7) deposited during the course of the seventh phase is a photosensitive polyimide and in that its removal over the photodiodes is performed by exposure through the substrate (1), the photodiodes serving as a mask, then by developing and removing the non-exposed parts and finally by heating the polyimide remaining between the photodiodes (E) at a temperature compatible with the said photodiodes (E).

14. The method as claimed in claim 1, characterized in that the semiconductor material of the layers (3, 4, 5, 9 and 10) deposited in the course of the second, third, fourth, tenth and twelfth phases is amorphous silicon.

15. The method as claimed in claim 1, characterized in that the layer (3) of the semiconductor material, deposited during the course of the second phase is a silicon carbon alloy.

16. The method as claimed in claim 1, characterized in that the twelfth and thirteenth phases of deposition of layers of semiconductor (10) and insulator (11) are performed through a mask for maintaining the periphery of the layer (2) of conductive material deposited in the course of the first phase in such a manner that the metallic lines (12) deposited in the course of the later phases give rise to contact means situated directly on the said layer of conductive material.

17. The method as claimed in claim 1, characterized in that the twelfth phase is one of deposition of electrically compensated semiconductor in order to diminish the photoconductivity thereof.

18. The method as claimed in claim 1, characterized in that the twelfth phase is one of deposition of weakly p doped semiconductor in order to diminish the photoconductivity thereof.

19. A bidimensional matrix detector comprising
- on a substrate (1) covered with a first layer of a conductive material (2), a matrix of photodiodes (E) in the form of studs arranged in lines and columns and each comprising as successive deposits a layer (3) of amorphous semiconductor with a first given type of doping (P or N), a layer (4) of amorphous semiconductor with a second type of doping (N or P) opposite to that of the first type, a layer (5) of amorphous semiconductor, a second layer (6) of a conductive material, each photodiode being insulated from the neighboring photodiodes by an insulating material (7);
- on the insulating material (7), columns of material (CL) placed in alignment with the columns of the photodiodes (E) and each comprising in successive deposits a layer of metallic material (8L) and a layer of amorphous doped semiconductor (9L);
- connection elements (CX) each connected with a photodiode (E) by the layer (6) of conductive material of the photodiode, situated in the vicinity of a column (CL) and each comprising in successive deposits a layer of metallic material (8X) and a layer of doped amorphous semiconductor (9X);
- lines of material (LG) arranged along the lines of the photodiodes (E), each line comprising as successive deposits a layer of non-doped amorphous semiconductor (10), a layer of insulator (11) and a layer of metallic material (12), the said lines spanning the said columns (CL) as well as a connection element (CX) at each point of intersection of a line (LG) and a column (CL).

20. The detector as claimed in claim 19, characterized in that the second layer of the conductive material (6) is transparent to the flux emitted by the luminous image.

21. The detector as claimed in claim 19, characterized in that the first layer of conductive material (2) is transparent to the flux emitted by the luminous image.

22. The detector as claimed in claim 20, characterized in that the first layer of conductive material (2) is opaque to the flux emitted by the luminous image.

### Patentansprüche

1. Verfahren zur Herstellung eines Lichtbildsensors, mit den folgenden aufeinanderfolgenden Phasen:
   a) eine erste Phase des Niederschlags einer ersten Schicht aus einem leitenden Material (2) auf einem Substrat (1);
   b) eine zweite Phase des Niederschlags einer Schicht (3) eines amorphen, in einer ersten bestimmten Art (P oder N) dotierten Halbleitermaterials;
   c) eine dritte Phase des Niederschlags einer Schicht (4) aus einem amorphen, nichtdotierten Halbleitermaterial;
   d) eine vierte Phase des Niederschlags einer Schicht (5) eines amorphen, in einer zur ersten Art der zweiten Phase inversen zweiten Art (N oder P) dotierten Halbleitermaterials;
   e) eine fünfte Phase des Niederschlags einer ersten Schicht aus einem metallischen Material (6);
   f) eine sechste Phase des Ätzens von Fotodioden (E) in denjenigen unterschiedlichen Schichten (3 bis 6), die vorher beginnend bei der zweiten Niederschlagsphase abgelagert worden sind, durch eine Maske;
   g) eine siebte Phase des Niederschlags einer ersten Schicht eines Isoliermaterials (7) mit einer Dicke, die gleich derjenigen der Fotodioden (E) ist;
   h) eine achte Phase der Bearbeitung des auf den Fotodioden (E) sich befindenden Isoliermaterials (7) so, daß das zwischen den Fotodioden (E) sich befindende Isoliermaterial erhalten bleibt;
   i) eine neunte Phase des Niederschlags einer zweiten Schicht eines metallischen Materials (8);
   j) eine zehnte Phase des Niederschlags einer Schicht (g) eines n-dotierten Halbleitermaterials;
   k) eine elfte Phase des Ätzens von jeweils mit einer Fotodiode (E) in Kontakt befindlichen Verbindungselementen (CX) und von auf dem Isoliermaterial (7) in der Nähe der Verbindungselemente (CX) angeordneten Säulen in der Schicht (9) aus im Verlauf der vorangehenden zehnten Phase abgelagertem Halbleitermaterial und in der zweiten Schicht aus metallischem Material (8) durch eine Maske;
   l) eine zwölfte Phase des Niederschlags einer Schicht (10) eines amorphen, nichtdotierten Halbleitermaterials;
   m) eine dreizehnte Phase des Niederschlags einer zweiten Schicht (11) eines Isoliermaterials;
   n) eine vierzehnte Phase des Niederschlags einer dritten Schicht (12) eines metallischen Materials;
   o) eine fünfzehnte Phase des Ätzens von mit den Verbindungselementen (CX) und den Säulen (CL) überlappenden und auf diese Weise Schalttransistoren bildenden Leitungen (LG) in den Schichten des Halbleitermaterials (10), des Isoliermaterials (11) und des metallischen Materials (12), die im Verlauf der vorangehenden zwölften, dreizehnten und vierzehnten Phase abgelagert worden sind, durch eine Maske.

2. Verfahren gemäß Anspruch 1, dadurch gekennzeichnet, daß die erste Schicht des leitenden Materials (2), das im Verlauf der ersten Phase abgelagert wird, gegenüber dem von einem Lichtbild emittierten Lichtstrom durchlässig ist und daß die erste Schicht aus metallischem Material (6), die im Verlauf der fünften Phase abgelagert wird, gegenüber diesem Lichtstrom undurchlässig ist.

3. Verfahren gemäß Anspruch 1, dadurch gekennzeichnet, daß die erste Schicht aus leitendem Material (2) gegenüber dem von einem Lichtbild emittierten Lichtstrom undurchlässig ist und daß die erste Schicht aus metallischem Material (6) gegenüber diesem Lichtstrom durchlässig ist.

4. Verfahren gemäß Anspruch 1, dadurch gekennzeichnet, daß die erste Schicht aus leitendem Material (2) und die erste Schicht aus metallischem Material (6) beide gegenüber dem von einem Lichtbild (6) emittierten Lichtstrom durchlässig sind.

5. Verfahren gemäß einem der Ansprüche 1, 2 oder 4, dadurch gekennzeichnet, daß das Substrat (1) aus einem gegenüber dem von einem Lichtbild emittierten Lichtstrom durchlässig ist.

6. Verfahren gemäß Anspruch 1, dadurch gekennzeichnet, daß die Verfahren des Niederschlags der Schichten aus Halbleitermaterial Glimmentladungsverfahren sind.

7. Verfahren gemäß Anspruch 1, dadurch gekennzeichnet, daß die Niederschläge der Schichten aus metallischem Material durch Hochvakuumaufdampfung bewerkstelligt werden.

8. Verfahren gemäß Anspruch 1, dadurch gekennzeichnet, daß die Niederschläge der Schichten aus metallischem Material durch Hochvakuumkathodenzerstäubung bewerkstelligt werden.

9. Verfahren gemäß Anspruch 1, dadurch gekennzeichnet, daß die sechste Phase des Ätzens eine Fotolithographie aufweist, die eine Maskierung der den Fotodioden (E) entsprechenden Zonen enthält, um fortlaufend eine Trockenätzung oder eine chemische Ätzung der im Verlauf der zweiten, dritten, vierten und fünften Phasen abgelagerten Schichten (3 bis 6) zu erhalten.

10. Verfahren gemäß Anspruch 1, dadurch gekennzeichnet, daß die siebte Phase durch Glimmentladung bewerkstelligt wird.

11. Verfahren gemäß Anspruch 1, dadurch gekennzeichnet, daß die siebte Phase durch reaktive Kathodenzerstäubung bewerktstelligt wird.

12. Verfahren gemäß den Ansprüchen 2 und 3 und 5, dadurch gekennzeichnet, daß die Beseitigung des Isolators auf den Fotodioden mittels eines Negativharzes und der Bestrahlung der im Verlauf der fünften Phase abgelagerten und als Maske dienenden Schicht aus metallischem Material (6) bewerkstelligt wird, wobei die Ätzung durch eine Trockentechnik vewirklicht wird.

13. Verfahren gemäß den Ansprüchen 2 und 5, dadurch gekennzeichnet, daß das im Verlauf der siebten Phase abgelagerte isolierende Material (7) ein fotoempfindliches Polyimid ist und daß dessen Beseitigung auf den Fotodioden durch Bestrahlung der als Maske dienenden Fotodioden durch das Substrat (1), dann durch Entwickeln und Abheben der nicht bestrahlten Bereiche und schließlich durch Entnehmen des zwischen den Fotodioden (E) verbleibenden Polyimids bei einer mit den Fotodioden (E) verträglichen Temperatur bewerkstelligt wird.

14. Verfahren gemäß Anspruch 1, dadurch gekennzeichnet, daß das Halbleitermaterial der Schichten (3, 4, 5, 9, 10), das im Verlauf der zweiten, dritten, vierten, zehnten und zwölften Phase abgelagert wird, amorphes Silizium ist.

15. Verfahren gemäß Anspruch 1, dadurch gekennzeichnet, daß die Schicht (3) aus Halbleitermaterial, die im Verlauf der zweiten Phase abgelagert wird, eine Siliziumkarbonatlegierung ist.

16. Verfahren gemäß Anspruch 1, dadurch gekennzeichnet, daß die zwölften und dreizehnten Phasen der Niederschläge der Halbleiterschicht (10) und der Isolierschicht (11) durch eine Maske bewerkstelligt werden, die den Rand der Schicht (2) aus leitendem Material erhält, welche im Verlauf der ersten Phase abgelagert wird, so daß die im Verlauf der späteren Phasen abgelagerten metallischen Leitungen (12) den direkt über der Schicht aus leitendem Material angeordneten Kontakten Raum geben.

17. Verfahren gemäß Anspruch 1, dadurch gekennzeichnet, daß die zwölfte Phase ein elektrisch kompensierter Niederschlag eines Halbleiters ist, um die Fotoleitfähigkeit zu verringern.

18. Verfahren gemäß Anspruch 1, dadurch gekennzeichnet, daß die zwölfte Phase ein Niederschlag eines leicht p-dotierten Halbleiters ist, um die Fotoleitfähigkeit zu verringern.

19. Zweidimensionaler Matrixsensor mit
- einer Fotodiodenmatrix in Gestalt von in Zeilen und Spalten angeordneten und jeweils mittels aufeinanderfolgender Niederschläge eine Schicht (3) eines amorphen, in einer ersten bestimmten Art (P oder N) dotierten Halbleiters, eine Schicht (4) eines amorphen, nichtdotierten Halbleiters, eine Schicht (5) eines amorphen, gemäß einer zur ersten Art inversen zweiten Art (N oder P) dotierten Halbleiters, eine zweite Schicht (6) eines leitenden Materials umfassenden Parzellen auf einem mit einer ersten Schicht eines leitenden Materials (2) beschichteten Substrat (1), wobei jede Fotodiode von den benachbarten Fotodioden durch ein Isoliermaterial (7) getrennt ist;
- Säulen (CL) aus einem entsprechend den Spalten der Fotodioden (E) abgelagerten Material auf einem Isoliermaterial (7), wobei jede Säule mittels aufeinanderfolgender Niederschläge eine Schicht aus einem metallischen Material (8L) und eine Schicht aus einem amorphen, dotierten Halbleiter (9L) umfaßt;
- Verbindungselementen (CX), die jeweils über die Schicht (6) der Fotodiode (E) aus leitendem Material mit einer Fotodiode (E) verbunden sind, in der Nähe einer Säule (CL) angeordnet sind und jeweils mittels aufeinanderfolgender Niederschläge eine Schicht aus metallischem Material (8X) und eine Schicht eines amorphen, dotierten Halbleiters (9 X) umfassen;
- Leitungen (LG) aus einem entsprechend den Zeilen der Fotodioden (E) abgelagerten Material, wobei jede Leitung mittels aufeinanderfolgender Niederschläge eine Schicht eines amorphen, nichtdotierten Halbleiters (10), eine isolierende Schicht (11) und eine Schicht eines metallischen Materials (12) umfaßt, wobei die Leitungen in jedem Kreuzungspunkt einer Leitung (LG) und einer Säule (CL) mit den Säulen (CL) sowie mit einem Verbindungselement (CX) überlappen und auf diese Weise Schalttransistoren ausbilden.

20. Sensor gemäß Anspruch 19, dadurch gekennzeichnet, daß die zweite Schicht aus leitendem Material (6) gegenüber dem von einem Lichtbild emittierten Strom durchlässig ist.

21. Sensor gemäß Anspruch 19, dadurch gekennzeichnet, daß die erste Schicht aus leitendem Material (2) gegenüber dem von einem Lichtbild emittierten Strom durchlässig ist.

22. Sensor gemäß Anspruch 20, dadurch gekennzeichnet, daß die erste Schicht aus leitendem Material (2) gegenüber dem von einem Lichtbild emittierten Strom undurchlässig ist.

# FIG_1

| | |
|---|---|
| METAL | 6 |
| Si n⁺ | |
| | 5 |
| Si (i) | 4 |
| | |
| Si P⁺ | 3 |
| ITO | 2 |
| SUBSTRAT | |
| | 1 |

# FIG_2

E

| | |
|---|---|
| METAL | 6 |
| Si n⁺ | 5 |
| Si (i) | 4 |
| Si P⁺ | 3 |
| ITO | 2 |
| SUBSTRAT | 1 |

# FIG_3

ISOLANT

| | |
|---|---|
| | 7 |
| METAL | 6 |
| Si n⁺ | 5 |
| Si (i) | 4 |
| Si P⁺ | 3 |
| ITO | 2 |
| SUBSTRAT | 1 |

ECLAIREMENT

# FIG_4

7        E    6

METAL
Si $n^+$    5
ISOLANT     Si $(i)$    4
Si $p^+$    3
ITO
2
1

# FIG_5

7       E     9

Si $n^+$    8
METAL
METAL    6
Si $(n)$    5
ISOLANT     Si $(i)$    4
Si $(P)$    3
ITO
2
1

# FIG_6

9L    CL      Cx    9X
8L        Si $n^+$    8X
METAL
E    6    5
METAL
Si $(n)$
ISOLANT     Si $(i)$
7       Si $(P)$
ITO
4   3   2
1

# FIG_7

9L
8L
12
11
10
METAL
ISOLANT
Si(L)
Si(i)
9X
Si n⁺
Si n⁺
METAL
METAL
METAL
Si (n)
8X
Si (i)
6
5
ISOLANT
Si (P)
ITO
7
4
3
2
1

# FIG_8

E
7
1

# FIG_9

# FIG_10

FIG_12

FIG_11